Europäisches Patentamt

European Patent Office

Office européen des brevets

(19)

(11) Numéro de publication : **0 461 032 A1**

# (12) DEMANDE DE BREVET EUROPEEN

(21) Numéro de dépôt : **91401469.1**

(51) Int. Cl.⁵ : **C23C 14/48, C23C 14/58**

(22) Date de dépôt : **05.06.91**

(30) Priorité : **08.06.90 FR 9007191**

(43) Date de publication de la demande :
**11.12.91 Bulletin 91/50**

(84) Etats contractants désignés :
**CH DE DK FR GB IT LI NL**

(71) Demandeur : **NITRUVID**
**9, Rue Jean Poulmarch Zone Industrielle du Val**
**F-95100 Argenteuil (FR)**

(72) Inventeur : **Abonneau, Eric**
**98 rue des Malles**
**F-26240 Saint-Vallier (FR)**
Inventeur : **Perez, Alain**
**29 Boulevard Anatole France**
**F-69006 Lyon (FR)**
Inventeur : **Fuchs, Gilbert**
**287 Trade Winda - Drive/4 San José**
**California 95123 (US)**
Inventeur : **Treilleux, Michel**
**9,Square des Violettes**
**F-69680 Chassieu (FR)**
Inventeur : **Chabrol, Claude**
**11, rue Saint Gérald**
**F-69700 Givors (FR)**

(74) Mandataire : **Jacobson, Claude et al**
**Cabinet Lavoix 2, Place d'Estienne d'Orves**
**F-75441 Paris Cedex 09 (FR)**

(54) **Procédé de réalisation d'un revêtement de haute adhérence sur un support métallique et notamment sur une tôle d'acier, et produit ainsi obtenu.**

(57) Suivant ce procédé, on dépose sur le support métallique par évaporation thermique un matériau formant une couche mince, et la couche mince est soumise à une opération de mixage par faisceau d'ions. On détermine la nature de l'ion de mixage, la dose d'ions et leur énergie de manière à obtenir une adhérence prédéterminée de la couche sur le support métallique.
Application aux tôles d'acier revêtues d'une céramique.

EP 0 461 032 A1

FIG.2

La présente invention concerne un procédé pour réaliser un revêtement de haute adhérence sur la surface d'un support métallique, pour obtenir des caractéristiques en surface, telles que des caractéristiques mécaniques pour améliorer la résistance par exemple au frottement ou à l'usure, chimiques pour améliorer la résistance par exemple à la corrosion, physiques pour améliorer les propriétés de collage et d'adhérence entre plusieurs supports, ou encore esthétiques, procédé du type dans lequel on dépose sur la surface de support une couche mince d'un matériau constituant tout ou partie du revêtement, la couche étant ensuite soumise à une opération de mélange par implantation ionique, opération connue sous le nom de "mixage par faisceau d'ions", les ions de mixage ayant une énergie cinétique suffisante pour traverser l'interface support/couche, générer des perturbations à l'échelle atomique à l'interface et améliorer ainsi l'adhérence de la couche.

Une publication de Materials Science and Engineering A 109 (1989) 83-88 ayant pour titre "ION BEAM MIXING of Cu-Al$_2$O$_3$ interfaces for Enhanced Adhesion" décrit un procédé de mixage par faisceau d'ions pour améliorer l'adhérence d'un film de cuivre déposé par évaporation sur un support en alumine. L'irradiation est réalisée avec des ions lourds de xénon soumis à un énergie cinétique d'environ 1,5 MeV, au moyen d'un accélérateur Van de Graaff.

L'usage d'ions de mixage de masse atomique élevée et de haute énergie est attaché à une démarche selon laquelle l'adhérence d'une couche mince déposée sur un support est d'autant plus grande que la perturbation créée à l'interface par mixage sera également plus grande. Cependant, les moyens nécessaires à la réalisation de l'irridiation sont extrêmement coûteux et ne peuvent être utilisés dans des applications industrielles.

Il existe également des procédés de dépôt de couche mince de type céramique sur un support, par exemple sous plasma électrique ou encore par pulvérisation ionique ou bombardement électronique après élévation en température du support. Ces techniques restent limitées au traitement de surface de petites pièces, et le chauffage du support constituerait une contrainte coûteuse dans le cas de supports de grandes dimensions. De plus, dans les techniques de dépôt par plasma électrique, la croissance de la couche céramique est lente.

On voit que les différentes techniques connues ne conviennent pas pour la réalisation industrielle de revêtements à couche mince sur un support métallique par exemple de grande surface. L'invention a pour but de réaliser un revêtement de haute adhérence sur la surface d'un support métallique pouvant être de grande surface en utilisant un procédé apte à être mis en oeuvre de façon continue et dans des conditions industriellement acceptables.

A cet effet, l'invention a pour objet un procédé du type précité, caractérisé en ce que :

 – on choisit l'ion de mixage et on détermine la dose d'ions et leur énergie de manière à obtenir, pour un support métallique et le matériau considérés, une adhérence prédéterminée de la couche sur le support métallique;

 – on effectue le dépôt par évaporation thermique dudit matériau pour déposer la couche sur le support métallique, ce support restant à peu près à la température ambiante pendant cette opération ; et

 – on implante l'ion de mixage choisi, avec la dose et l'énergie déterminées.

Suivant d'autres caractéristiques du procédé selon l'invention :

 – l'énergie cinétique d'implantation de l'ion de mixage est inférieure à 200 keV environ ;

 – la couche mince est constituée de carbone ou d'un matériau céramique;

 – la céramique est un oxyde réfractaire tel que l'alumine ou la silice ;

 – on peut effectuer, après l'opération de mixage, un recuit du support métallique et de la couche mince ;

 – les ions de mixage sont choisis parmi les éléments ayant une masse atomique comprise dans l'intervalle 10-40, notamment parmi le néon, l'argon, l'oxygène et l'azote ;

 – l'épaisseur de la couche mince du matériau est inférieure à 0,5 µm, et notamment comprise entre 0,01 et 0,2 µm.

 – on peut également réaliser sur la couche mince, après l'opération de mixage, un dépôt d'un matériau de même nature, d'épaisseur désirée, afin d'obtenir un revêtement adhérent d'épaisseur déterminée ;

 – la dose implantée des ions de mixage est comprise entre $10^{15}$ et $10^{16}$ ions/cm$^2$ environ ;

 – simultanément ou après le mixage, la couche mince peut être colorée par implantation ionique, les ions de colorations étant notamment choisis parmi les éléments métalliques de transition ;

 – les ions de coloration sont implantés de façon que dans leur répartition dans le revêtement, leur densité maximale se situe près de l'interface support/couche mince.

L'invention a également pour objet un produit constitué d'un support métallique sur lequel est réalisé un revêtement comportant au moins une couche mince adhérant sur le support, ce produit étant obtenu par un procédé tel que défini ci-dessus.

Le revêtement peut être constitué de plusieurs couches minces composées de matériaux de nature différente ou de même nature.

Ce produit peut être une tôle d'acier revêtue pour assurer une protection contre la corrosion associée ou non à une coloration, ou une meilleure adhérence de plusieurs tôles pour former un sandwich. Dans un autre exemple d'application, le produit peut être une partie de frottement d'une prothèse articulaire médicale.

Le description qui suit, faite en regard du dessin annexé, fera mieux comprendre l'invention.

La figure 1 est un schéma de principe du test de traction utilisé pour la mesure de l'adhérence d'une couche mince sur un support.

La figure 2 présente les caractéristiques d'adhérence mesurées par le test de traction en fonction des doses d'implantation des ions de mixage, pour des ions de masse différente et d'énergie variable.

Le procédé selon l'invention comporte une suite d'opérations couramment utilisées dans l'industrie :

– une évaporation thermique sous vide d'un matériau sur un support métallique par exemple de grande surface, pour la réalisation d'une couche mince déposée d'épaisseur inférieure à 0,5 µm. L'élévation de la température du matériau à évaporer est réalisée soit par effet Joule soit à l'aide d'un canon à électrons. Lors de l'évaporation, le support est à peu près à la température ambiante, ce qui donne à ce stade du procédé une couche mince déposée relativement peu adhérente. Par "à peu près à la température ambiante", on entend que le support ne subit aucun chauffage spécifique en vue de cette opération de dépôt par évaporation thermique. L'opération de mixage consécutive assure l'adhérence de la couche interne.

– une opération de mixage,

Au cours du mixage, c'est-à-dire lors de l'interaction des ions implantés avec la matière, il y a perte d'énergie des ions par des interactions électroniques et par des interactions nucléaires. Cette interaction se décompose en deux phases :

– une phase balistique primaire indépendante de la température, et

– une phase chimique secondaire dépendante de la température et pendant laquelle ont lieu notamment les phénomènes de diffusion assistée.

Cette constatation permet la détermination, préalablement au mixage, d'une valeur optimale d'énergie de transfert au niveau de l'interface, valeur liée au niveau d'adhérence désiré. Cette énergie a été analysée comme étant fonction de la nature du support et du matériau constituant la couche mince, de la nature de l'ion de mixage choisi, de l'énergie cinétique d'implantation, de la dose des ions de mixage implantée et de la répartition des pertes d'énergies d'interactions électroniques et d'interactions nucléaires de l'ion dans la matière, au niveau de l'interface.

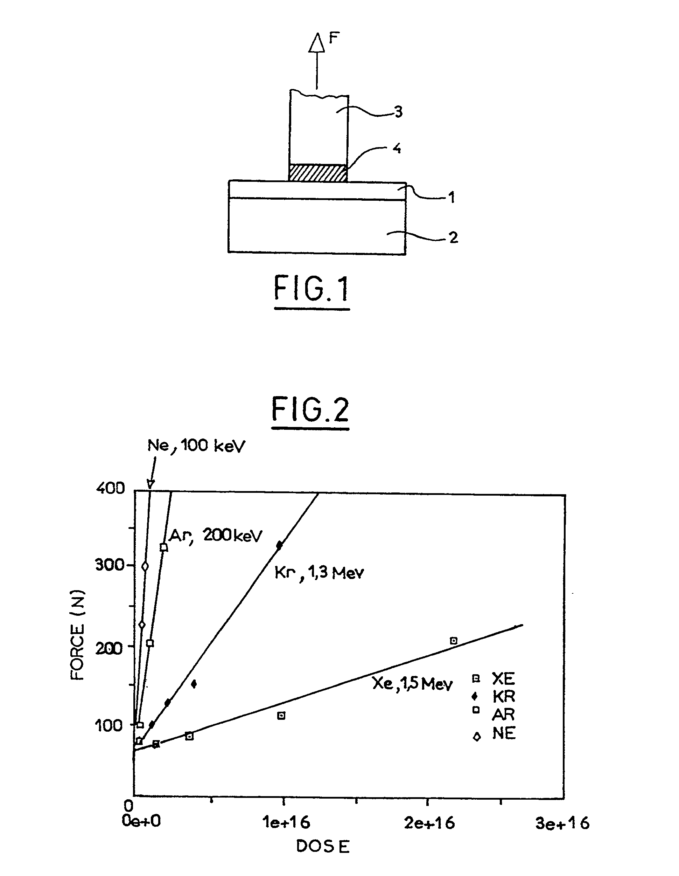

La figure 1 décrit un test de traction pour la mesure des caractéritiques d'adhérence.

Un matériau 1 déposé en couche mince sur un support 2 est soumis à une traction par l'intermédiaire d'une tige 3, par exemple métallique, liée par son extrémité à la couche mince par une colle 4.

Dans l'exemple de mise en oeuvre décrit ci-dessous, le procédé pour la réalisation d'un revêtement de haute adhérence comporte une évaporation thermique par canon à électrons d'une couche de 0,1 um d'alumine sur un support en acier suivie d'une opération de mixage par différents ions de masse et d'énergie variables.

La figure 2 représente différentes caractéristiques d'adhérences, mesurées au moyen du test de la figure 1, en fonction des doses d'implantation des ions de mixage. Les ions testés sont entre autres le xénon, le krypton, l'argon et le néon, à différentes énergies cinétiques.

D'une façon remarquable et inattendue, on a constaté que l'adhérence augmente de façon considérable, pour une dose donnée, lorsque la masse atomique de l'ion de mixage est inférieure à 40 environ.

Lors de l'utilisation d'ions de mixage de masse atomique inférieure à 10, le transfert d'énergie à l'interface est dominé par les pertes d'interaction électronique, interaction quine perturbe plus de façon suffisante la matière à l'interface et n'améliore pas autant par conséquent l'adhérence de la couche.

Compte tenu de la masse des ions de mixage selon l'invention, il est alors possible d'utiliser une énergie d'implantation faible, inférieure à 200keV environ, une telle énergie d'implantation pouvant être obtenue avec des implanteurs d'ions industriels classiques.

Les doses nécessaires pour améliorer l'adhérence de manière importante sont également faibles, c'est à dire inférieures à $10^{16}$ ions/cm$^2$, ce qui permet une implantation en des temps très courts, et est donc favorable à l'industrialisation du procédé.

On a constaté par ailleurs qu'un recuit après mixage améliore d'un facteur d'environ 2 la valeur de la caractéristique d'adhérence.

Si pour des raisons technologiques, l'épaisseur de la couche est insuffisante pour former le revêtement, il peut être déposé sur la couche adhérente après mixage, par tout procédé approprié, par exemple par bombardement électronique, une couche plus épaisse d'un matériau de même caractéristique physicochimique.

Le revêtement de haute adhérence peut être coloré par une implantation ionique, les ions d'implantation étant choisis parmi les éléments métalliques de transition et implantés avec une énergie choisie de manière que dans leur répartition dans le revêtement adhérent, leur densité maximale se situe près de l'interface.

Ainsi, le revêtement de haute adhérence sur un support métallique est obtenu selon l'invention par un procédé pour lequel il est nécessaire d'effectuer :

– une simple évaporation thermique d'un matériau tel qu'une céramique comme par exemple l'alumine, la silice ou un autre corps particulier comme le carbone, et

– un mixage sous une faible dose d'ions légers tels que le néon, l'argon, l'azote, l'oxygène, soumis à une énergie cinétique inférieure à 200keV fournie par un simple dispositif d'implantation industriel, le revêtement pouvant être de plus coloré, simultanément ou consécutivement à l'opération de mixage, par une implantation d'ions métallique de transition.

Le procédé permet aussi la réalisation d'un revêtement de plusieurs couches de matériaux différents, par exemple pour des applications en optique.

Le procédé, qui fournit un moyen pour améliorer l'adhérence d'une couche mince par exemple céramique sur un support métallique, peut être utilisé dans divers domaines techniques industriels où une caractéristique de surface est recherchée, comme par exemple un dépôt en couche mince d'une céramique sur un métal pour obtenir une résistance à la corrosion ou à l'usure, une isolation électrique ou électromagnétique en surface, une bonne adhérence, ou encore une coloration particulière dans un but esthétique.

## Revendications

1. Procédé pour réaliser un revêtement de haute adhérence sur la surface d'un support métallique, du type dans lequel on dépose sur la surface du support une couche mince d'un matériau constituant tout ou partie du revêtement, la couche étant ensuite soumise à une opération de mixage par faisceau d'ions, les ions de mixage ayant une énergie cinétique suffisante pour traverser l'interface support/couche, générer des perturbations à l'échelle atomique à l'interface et améliorer ainsi l'adhérence de la couche, caractérisé en ce que :
   – on choisit l'ion de mixage et on détermine la dose d'ions et leur énergie de manière à obtenir, pour un support métallique et le matériau considérés, une adhérence prédéterminée de la couche sur le support métallique;
   – on effectue le dépôt par évaporation thermique dudit matériau pour déposer la couche sur le support métallique, ce support restant à peu près à la température ambiante pendant cette opération ; et
   – on implante l'ion de mixage choisi, avec la dose et l'énergie cinétique déterminées.

2. Procédé selon la revendication 1, caractérisé en ce que l'énergie cinétique d'implantation de l'ion de mixage est inférieure à 200 keV.

3. Procédé selon la revendication 1 ou 2, caractérisé en ce que les ions de mixage sont choisis parmi les éléments ayant une masse atomique comprise dans l'intervalle (10-40), notamment parmi le néon, l'argon, l'oxygène et l'azote.

4. Procédé selon l'une quelconque des revendications 1 à 3, caractérisé en ce que la dose implantée des ions de mixage est comprise entre $10^{15}$ et $10^{16}$ ions/cm² environ.

5. Procédé selon l'une quelconque des revendications 1 à 4, caractérisé en ce que la couche mince est constituée de carbone ou d'un matériau céramique, notamment d'un oxyde réfractaire tel que l'alumine ou la silice.

6. Procédé selon l'une quelconque des revendications 1 à 5, caractérisé en ce que l'épaisseur de la couche mince est inférieure à 0,5 μm, et notamment comprise entre 0,01 et 0,2 μm.

7. Procédé selon l'une quelconque des revendications 1 à 6, caractérisé en ce qu'on effectue après l'opération de mixage par faisceau d'ions un recuit du support métallique et de la couche mince.

8. Procédé selon l'une quelconque des revendications 1 à 7, caractérisé en ce qu'après l'opération de mixage par faisceau d'ions, on réalise sur la couche mince un dépôt d'un matériau de même nature, d'épaisseur désirée.

9. Procédé selon l'une quelconque des revendications 1 à 8, caractérisé en ce que simultanément ou après mixage, la couche mince est colorée par implantation ionique, les ions de coloration étant notamment choisis parmi les éléments métalliques de transition.

10. Procédé selon la revendication 9, caractérisé en ce que les ions de coloration sont implantés de façon que dans leur répartition dans le revêtement, leur densité maximale se situe près de l'interface.

11. Produit constitué d'un support métallique, notamment d'une tôle d'acier, sur lequel est réalisé un revêtement comportant au moins une couche mince adhérant sur le support, caractérisé en ce que ce produit est obtenu par un procédé selon l'une quelconque des revendications 1 à 10.

12. Produit selon la revendication 11, caractérisé en ce que le revêtement est constitué de plusieurs couches minces composées de matériaux de nature différentes ou de même nature.

13. Produit selon la revendication 11 ou 12, caractérisé en ce qu'il constitue une partie de frottement d'une prothèse articulaire médicale.

FIG.1

FIG.2

Office européen
des brevets

# RAPPORT DE RECHERCHE EUROPEENNE

Numero de la demande

EP    91 40 1469

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | US-A-4 673 587 (O. KAMIGAITO ET AL) | 1-6 | C23C14/48 |
| A | * colonne 2, ligne 1 - colonne 4, ligne 52 * | 11 | C23C14/58 |
| | --- | | |
| A | NUCLEAR INSTRUMENTS AND METODS IN PHYSICS RESEARCH vol. B7/8, no. 1, 1 Mars 1985, AMSTERDAM,NL pages 881 - 885; J.E.E.BAGLIN ET AL: 'ion beam bonding of thin films ' * page 881, colonne 2, ligne 11 - ligne 24 * * page 883, colonne 1, ligne 38 - ligne 49 * * page 883, colonne 2, ligne 1 - ligne 15 * | 7,8,12 | |
| | --- | | |
| A | NUCLEAR INSTRUMENTS AND METHODS IN PHYSICS RESEARCH, SECTION B vol. B7/8, no. 1, 1 Mars 1985, AMSTERDAM NL pages 184 - 187; Y. OKABE ET AL.: 'coloring of iron surface controlled by ti+-o+ double ion implantations ' * page 184, colonne 2, ligne 6 - ligne 33 * * page 185, colonne 1, ligne 1 - ligne 10; tableau 1 * | 9 | |
| | --- | | |
| A | DE-A-2 632 932 (DORNIER SYSTEM GMBH) * revendications 1-2 * | 13 | DOMAINES TECHNIQUES RECHERCHES (Int. Cl.5) C23C A61L |
| | ----- | | |

Le présent rapport a été établi pour toutes les revendications

| Lieu de la recherche | Date d'achèvement de la recherche | Examinateur |
|---|---|---|
| LA HAYE | 10 SEPTEMBRE 1991 | EKHULT H. U. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

........................................................

& : membre de la même famille, document correspondant